(19) Europäisches Patentamt
European Patent Office
Office européen des brevets

(11) **EP 2 747 290 A1**

(12) **EUROPEAN PATENT APPLICATION**

(43) Date of publication:
**25.06.2014 Bulletin 2014/26**

(51) Int Cl.:
**H03M 1/06** $^{(2006.01)}$

(21) Application number: **12197778.9**

(22) Date of filing: **18.12.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ams AG**
**8141 Unterpremstätten (AT)**

(72) Inventor: **Steiner, Matthias**
**8054 Seiersberg (AT)**

(74) Representative: **Epping - Hermann - Fischer Patentanwaltsgesellschaft mbH Schloßschmidstraße 5 80639 München (DE)**

(54) **Analog-to-digital converter system, sensor arrangement and method for analog-to-digital conversion**

(57)   An analog-to-digital converter system comprises an analog-to-digital converter circuit (ADC), a reference compensation block (COMP) and a reference terminal (REF1) for receiving an analog first reference signal (sref1). The analog-to-digital converter circuit (ADC) has a reference input (REF2) and a signal input (SIG) and is configured to generate a digital output signal (dig), which corresponds to an analog input signal (ssig) being present at the signal input (SIG), on the basis of the input signal (ssig) and an analog second reference signal (sref2) being present at the reference input (REF2). The reference compensation block (COMP) is configured to generate the second reference signal (sref2) by superposing a signal being derived from the input signal (ssig), in particular being proportional to the input signal (ssig), onto the first reference signal (sref1).

## Fig 1

EP 2 747 290 A1

**Description**

The invention relates to an analog-to-digital converter system, to a sensor arrangement with such an analog-to-digital converter system and to a method for analog-to-digital conversion.

Analog-to-digital converters are widely used for converting various analog signals into the digital domain. For example, signals of analog sensors or the like are converted to a corresponding digital signal. Usually, it is attempted to perform the conversion with a grade of linearity in order to avoid introduction of error components into the digital signal.

In some applications, for example with analog sensors, a quantity to be measured with the analog sensor leads to a non-linear dependency of the resulting analog sensor signal. With a conventional analog-to-digital converter, this non-linearity is transferred to the digital domain. If the source of the non-linearity is known, the non-linearity may be cancelled out by calculation in the digital domain. However, such calculations increase the effort needed for signal processing.

An object to be achieved is to provide an improved concept for compensating non-linear behaviour of an analog signal with an analog-to-digital converter.

This object is achieved with the subject-matter of the independent claims. Embodiments and developments of the improved concept are the subject-matter of the dependent claims.

The improved concept is based on the idea that in a conventional analog-to-digital converter, the digital output is determined on the basis of a ratio between the signal to be converted and a reference signal. Hence, according to the improved concept, a signal being derived from the signal to be converted, preferably being proportional to the signal to be converted, is so to say modulated on the reference signal being used by the analog-to-digital converter, which results in the deliberate introduction of a non-linearity into the conversion process, which can counteract an unwanted non-linearity in the signal to be converted. In other words, a non-linearity within a signal to be converted can be partially or completely compensated for by the analog-to-digital conversion process according to the improved concept.

An embodiment of an analog-to-digital converter system according to the improved concept comprises a reference terminal for receiving an analog first reference signal, which preferably is a constant or fixed reference signal. The system further comprises an analog-to-digital converter circuit having a reference input and a signal input and being configured to generate a digital output signal, which corresponds to an analog input signal being present at the signal input, on the basis of the input signal and an analog second reference signal being present at the reference input. The system further comprises a reference compensation block, which is configured to generate the second reference signal by superposing a signal being derived from the input signal, preferably being proportional to the input signal, onto the first reference signal.

The analog-to-digital converter circuit comprised by the analog-to-digital converter system according to the improved concept may therefore be any kind of conventional analog-to-digital converter that uses a reference signal in order to generate a digital output signal corresponding to an analog input signal. For example, the analog-to-digital converter circuit comprises a direct conversion analog-to-digital converter, a successive approximation analog-to-digital converter, an integrating analog-to-digital converter, a sigma-delta analog-to-digital converter or any combination of such converters. The analog-to-digital converter circuit may also comprise a switched capacitor integrator, for example for processing the analog input signal.

According to the improved concept, by choosing a specific proportionality factor for the generation of the second reference signal, any kind of undesired non-linearities within the analog input signal may be compensated, which preferably have a non-linearity that may have a reciprocal dependency on a quantity to be measured.

For example, the reference compensation block is configured to generate the second reference signal on the basis of a proportionality factor k, such that

$$(1) \qquad sref2 \approx sref1 + k \cdot ssig,$$

with sref1 being the first reference signal, sref2 being the second reference signal, and ssig being the input signal.

Equation (1) states an approximate relationship, as some inaccurateness may be introduced by circuit parts or the like. However, it is desirable to accomplish the relationship of equation (1) as well as possible.

The proportionality factor k preferably is chosen depending on a more or less known non-linearity of the input signal to be converted. For example, the input signal may be produced by any kind of sensor or measured within a circuit or the like, which have known physical properties. Hence, a value for the proportionality factor k can be calculated during design or implementation of the analog-to-digital converter system according to the improved concept. However, even if only the kind of non-linearity of the signal to be converted is known, but not by value, at least a partial compensation of the non-linearity can be achieved. Furthermore, the proportionality factor k may be adjustable.

For example, the analog-to-digital converter system is configured to be operated in a normal mode of operation, during which the proportionality factor k is held constant and, in a calibration mode of operation, during which the proportionality factor k is adaptable.

As an alternative, or in addition, the proportionality factor k may be selectable from a predetermined set of proportionality factors.

According to one embodiment of the analog-to-digital converter system, the input signal is a sensor signal that has a desired dependency on a quantity to be measured and further has a non-linear dependency, in particular reciprocal dependency, on the quantity to be measured. Hence, the proportionality factor k is matched to the non-linear or reciprocal dependency, for example such that the non-linear or reciprocal dependency is compensated for.

The term "reciprocal dependency" defines that the input signal inter alia has a dependency on a formula, in which the quantity to be measured stands in the denominator of the formula, with or without any additive components. Preferably, such a formula is known in advance when implementing the analog-to-digital converter system for use with a sensor signal of that kind. In general, any non-linear dependency may be expressed as a series, in particular Taylor-series, depending on the quantity to be measured. Such non-linearities may be compensated for by the improved concept.

The analog-to-digital converter circuit may be operated with different kinds of signals or signal types, in particular voltages, currents or charges. Accordingly, the first reference signal, the second reference signal and the input signal are respectively one of the following: a voltage signal, a current signal, a charge signal.

Accordingly, the reference compensation block may be implemented in different ways, for example with a conventional voltage adder, a current adder or by a circuit for adding charges, e.g. by means of capacitors.

With the implementation of the proportionality factor k, a digital signal dig at the output of the analog-to-digital converter circuit and the analog-to-digital converter system, respectively, is proportional to the ratio between the input signal and the second reference signal, for example according to:

$$(2) \qquad dig \sim \frac{ssig}{sref2} = \frac{ssig}{sref1 + k \cdot ssig} \, .$$

An analog-to-digital converter according to one of the embodiments described above may be used within a sensor arrangement. The sensor arrangement according to one embodiment comprises a sensor module, whose output is connected to the signal input of the analog-to-digital converter system for providing the input signal. Accordingly, an output of the analog-to-digital converter system may form the output of the sensor arrangement. For example, a sensor signal provided by the sensor module is used as the input signal.

The implementation of the sensor arrangement allows the provision of a digital output signal corresponding to a quantity to be measured by the sensor module with undesired non-linearities compensated for.

For example, the sensor module comprises a capacitive sensor element for generating the input signal. The non-linearity to be compensated for may be generated by this capacitive sensor element.

In a specific implementation, the sensor module comprises a capacitive micro-electromechanical systems, MEMS, sensor element, for example a MEMS microphone.

MEMS microphones convert the sound pressure of an acoustic wave into the movement of at least one plate used as one of two capacitor plates. This movement results in a change of capacitance, which can be sensed by respective measurements.

If further capacitances are present in the sensor module, the resulting sensor signal, namely the input signal for the analog-to-digital converter, may comprise one of the above-described reciprocal non-linear dependencies. However, with the improved concept, the analog-to-digital converter system compensates for these non-linearities.

For example, a sensor module with a capacitive MEMS sensor element may further comprise an amplifier circuit and a bias voltage source, wherein the MEMS sensor element is connected between the bias voltage source and an amplifier input of the amplifier circuit. The non-linearities may be generated due to parasitic capacitances at the input of the amplifier circuit.

According to one specific implementation, the sensor module further comprises a high ohmic resistive element that is connected between the amplifier input and a ground terminal. For example, the resistive element has a resistance in the order of several gigaohms to teraohms. The resistance element may be used to define an operating point of the amplifier circuit.

Additionally, or as an alternative, the sensor module may further comprise a capacitive element that is connected between the amplifier input and the ground terminal. This capacitive element can be used to take charges of the capacitive MEMS sensor element in order to reduce an amplitude of the signal at the amplifier input. This may avoid over-voltages or out of range voltages within the amplifier circuit. Accordingly, the dynamic range of the capacitive sensor element can be increased by this measure. However, similar to the parasitic capacitances described before, the additional capacitive element at the amplifier input can generate a non-linearity within the sensor signal or the input signal of the analog-to-digital converter system. According to the improved concept, these non-linearities can be compensated for advantageously.

In a further specific implementation, the amplifier circuit is an operational amplifier, wherein an amplifier output of the amplifier circuit is connected to the amplifier input by an RC parallel connection and the further amplifier input is connected to a ground terminal. In this implementation, the capacitance of the RC parallel connection may introduce the non-linearities that are compensated by the improved concept.

According to an embodiment of a method for analog-to-digital conversion, an analog first reference signal, in particular a fixed or a constant reference signal is received. Furthermore, an analog input signal is received. An analog second reference signal is generated by superposing a signal being proportional to the input onto the first reference signal. A digital output signal is generated, which corresponds to the input signal, wherein the generation is performed on the basis of the input signal and the second reference signal. Preferably, the digital output signal is based on a ratio between the input signal and the second reference signal.

With the method according to the improved concept, non-linearities within the input signal can be compensated for, such that the digital output signal is a linear representation of desired components of the input signal, as described before for the various embodiments of the analog-to-digital converter system and the sensor arrangement.

According to one implementation of the method, the input signal is a sensor signal that has a desired dependency on a quantity to be measured and further has a reciprocal dependency on the quantity to be measured, wherein a proportionality factor k, which is used for generating the second reference signal, is matched to the reciprocal dependency. In particular, the proportionality factor k is chosen such that the unwanted reciprocal dependency on the quantity to be measured is compensated for.

Further implementations and embodiments of the method become apparent from the various embodiments described for the analog-to-digital converter system and the sensor arrangement described above.

The text below explains the invention in detail using exemplary embodiments with reference to the drawings. Components and circuit elements that are functionally identical or have the identical effect bear identical reference numbers. In so far as circuit parts or components correspond to one or another function, description of them will not be repeated in each of the following figures.

In the drawings:

Figure 1    shows an embodiment of an analog-to-digital converter system,

Figure 2    shows an embodiment of a sensor arrangement,

Figure 3    shows a further embodiment of a sensor arrangement,

Figure 4    shows a detail of a further embodiment of an analog-to-digital converter system,

Figure 5    shows a further embodiment of an analog-to-digital converter system,

Figure 6    shows a further embodiment of an analog-to-digital converter system, and

Figure 7    shows a further embodiment of an analog-to-digital converter system.

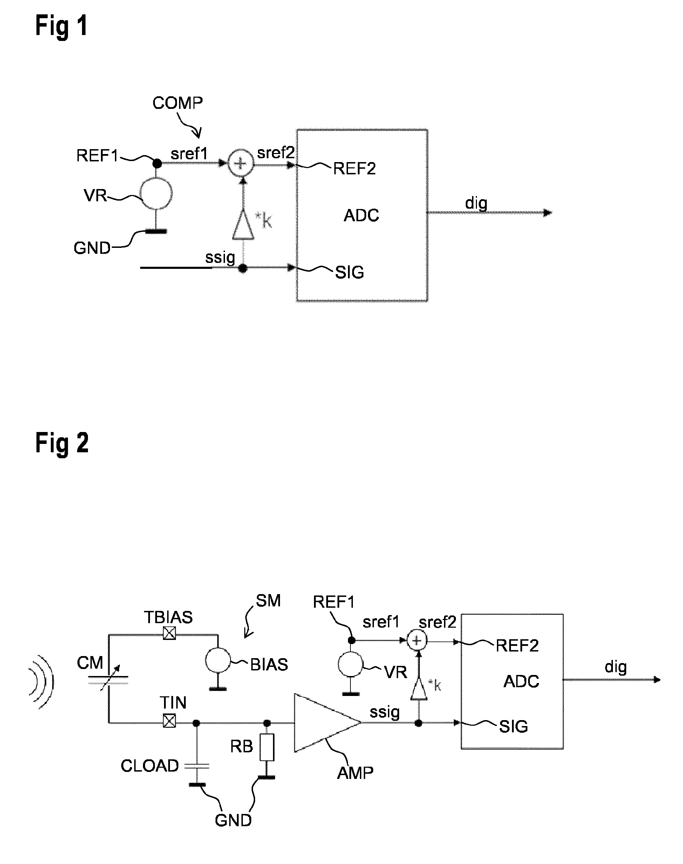

Figure 1 shows an embodiment of an analog-to-digital converter system that comprises an analog-to-digital converter circuit ADC and a reference compensation block COMP. The analog-to-digital converter circuit ADC has a reference input REF2, a signal input SIG and is configured to provide a digital output dig at its output. The analog-to-digital conversion is performed on the basis of an input signal ssig to be converted, which is provided to the signal input SIG, and a reference signal sref2 provided as the reference input REF2.

The analog-to-digital converter system further comprises a reference source VR, which is shown as a voltage source and which is connected between a reference terminal REF1 and a ground terminal GND. The reference compensation block COMP is shown with a multiplier and an adder for describing the main function of the reference compensation block COMP. In particular, the reference compensation block COMP is configured to use a first reference signal sref1 provided by the reference source VR and to generate the second reference signal sref2 by superposing a signal being directly derived from the input signal ssig, in particular being proportional to the input signal ssig, onto the first reference signal sref1. The proportionality is expressed by the proportionality factor k of the multiplier. Expressed as a formula, the function of the reference compensation block may be written as:

$$(3) \qquad \texttt{sref2} \approx \texttt{sref1} + \texttt{k·ssig.}$$

The analog-to-digital converter circuit ADC may be implemented as any well-known analog-to-digital converter which is based on the principle of determining some kind of ratio between the input signal ssig to the second reference signal sref2 in order to generate the digital output signal dig.

For the sake of completeness, some possible implementations of the analog-to-digital converter circuit are named in the following, however, without limiting the use of other implementations. For example, the analog-to-digital converter circuit ADC may be implemented by or comprise a direct conversion analog-to-digital converter, a successive approximation analog-to-digital converter, an integrating analog-to-digital converter, a sigma delta analog-to-digital converter or the like. The circuit ADC may also comprise a switched capacitor integrator, for example as a frontend to any of the above-named converter types.

The analog-to-digital converter system according to the improved concept shown in Figure 1 deliberately modulates the fixed reference signal sref1 provided by the reference source VR with the input signal ssig to be converted, such that a signal transfer function of the system becomes non-linear. Based on the ratio between input signal ssig and reference signal sref2, the digital output signal dig is based on the following equation:

$$(4) \qquad \texttt{dig} \sim \frac{\texttt{ssig}}{\texttt{sref2}} = \frac{\texttt{ssig}}{\texttt{sref1}+\texttt{k·ssig}} \, .$$

This non-linear transfer function can be used to compensate for non-linear dependencies on a quantity to be measured within the input signal ssig, which may be undesired within the digital output signal dig. This may be particularly advantageous if the input signal ssig is a sensor signal that has a desired dependency on the quantity to be measured and further has a reciprocal dependency on the quantity to be measured. In this case, the proportionality factor k can be matched to the reciprocal dependency. In particular, matching may comprise selecting the value of the proportionality factor k such that the non-linearities of the input signal and the non-linearity of the transfer function of the analog-to-digital converter system cancel out each other partially or completely.

Figure 2 shows an embodiment of a sensor arrangement that includes an analog-to-digital converter system as described for Figure 1. In particular, the right-hand side of the circuit shown in Figure 2 corresponds to the circuit shown in Figure 1. Accordingly, these circuit parts will not be described in full detail again.

The sensor arrangement comprises a sensor module SM in which a capacitance of a capacitive sensor element CM is measured. For example, the capacitive sensor element CM is a capacitive MEMS microphone, which changes its capacitance value depending on sound waves shown on the left-hand side of Figure 2. To this end, the capacitive sensor element CM is connected between a bias connection TBIAS and an input terminal TIN of an amplifier AMP. A constant DC biasing voltage $V_{M0}$ is applied to the sensor element CM by means of the bias voltage source BIAS. A resistive element RB is connected between the input terminal TIN and the ground terminal GND with a high impedance. Accordingly, a resistor with a high resistance value in the range of several gigaohms or teraohms, is provided between the input terminal TIN and the ground terminal GND. Alternatively to a resistor, back-to-back connected diodes can be used, the high resistive value being achieved by operating the diodes in the lower passband range, markedly below the forward voltage. Consequently, a mean voltage value at the operating point at the input terminal TIN is substantially as high as the value at the ground terminal GND.

Furthermore, a loading capacitor CLOAD is connected between the input terminal TIN and the ground terminal GND.

During operation of the sensor arrangement, the sound waves lead to a change in capacitance of the capacitive sensor element CM and therefore a change of voltage across the sensor element CM. These voltage variations are amplified by the amplifier AMP in order to produce the input signal ssig or the analog-to-digital converter circuit ADC. For sound waves of high amplitude, voltage variations may occur that are beyond the input range of the amplifier AMP. According to the embodiment shown in Figure 2, the voltage variations are reduced by transferring charge from the capacitive sensor element to the loading capacitor CLOAD. Hence, significant signal distortions at loud acoustic levels can be avoided by using the loading capacitor CLOAD.

However, the charge transfer may lead to undesired effects in the resulting signal at the input terminal TIN, which will be explained in more detail in the following on the basis of a capacitive MEMS microphone sensor.

In a capacitive MEMS microphone sensor CM the audio pressure is converted into a displacement $\Delta d_M$ of one of its two parallel plates. This results in a non-linear change of the respective capacitance $C_M$ between the two plates

since $\Delta d_M$ stands in the denominator:

$$(5) \qquad C_M = \varepsilon \frac{A_M}{d_{M0} + \Delta d_M}$$

Applying the constant DC biasing voltage $V_{M0}$ of the voltage source BIAS across sensor CM gives a constant charge $Q_{M0}$ stored on the sensor element CM in the frequency range of interest. By measuring a resulting AC voltage change $\Delta V_M$, this non-linear 1/x relationship is rectified again to obtain a linear relationship between the quantity to be measured, namely audio pressure, and the output AC voltage:

With

$$(6) \qquad V_M = \frac{Q_{M0}}{C_M} = \frac{C_{M0} \cdot V_{M0}}{C_M} = V_{M0} \cdot \frac{d_{M0} + \Delta d_M}{d_{M0}},$$

it is found that

$$(7) \qquad \Delta V_M = \frac{Q_{M0}}{C_M} - \frac{Q_{M0}}{C_{M0}} = V_{M0} \cdot \left(\frac{d_{M0} + \Delta d_M}{d_{M0}} - 1\right) = V_{M0} \cdot \frac{\Delta d_M}{d_{M0}}$$

This linear relationship between $\Delta d_M$ and $\Delta V_M$ is beneficial for the sensor application in terms of distortion.

However, this relationship applies only if the MEMS sensor CM is unloaded and the sensor charge $Q_{M0}$ is constant in the frequency range of interest. If the sensor is loaded with the loading capacitor CLOAD having capacitance $C_{load}$, the charge on the sensor is no longer constant, and it can be shown that the relationship changes to:

$$(8) \qquad \Delta V_M = V_{M0} \cdot \frac{C_{M0}}{C_{load}} \cdot \frac{\dfrac{\Delta d_M}{d_{M0}}}{1 + \dfrac{\Delta d_M}{d_{M0}} + \dfrac{C_{M0}}{C_{load}}}$$

Now the quantity to be measured $\Delta d_M$ is also present in the denominator, which makes the relationship non-linear and therefore introduces signal distortion. In particular, a reciprocal dependency is present between the quantity to be measured $\Delta d_M$ and the resulting AC voltage change $\Delta V_M$.

Using the sensor signal $\Delta V_M$ as the input signal ssig, a reference voltage $V_{ref}$ as the first reference signal sref1, and referring back to equation (4), the overall tranfer function becomes:

$$(9) \quad \text{dig} \sim \frac{\Delta V_M}{V_{ref} + k \cdot \Delta V_M} =$$

$$\frac{V_{M0} \cdot \dfrac{C_{M0}}{C_{load}} \cdot \dfrac{\dfrac{\Delta d_M}{d_{M0}}}{1 + \dfrac{\Delta d_M}{d_{M0}} + \dfrac{C_{M0}}{C_{load}}}}{V_{ref} + k \cdot V_{M0} \cdot \dfrac{C_{M0}}{C_{load}} \cdot \dfrac{\dfrac{\Delta d_M}{d_{M0}}}{1 + \dfrac{\Delta d_M}{d_{M0}} + \dfrac{C_{M0}}{C_{load}}}} =$$

$$\frac{V_{M0} \cdot \dfrac{C_{M0}}{C_{load}} \cdot \dfrac{\Delta d_M}{d_{M0}}}{V_{ref} \cdot (1 + \dfrac{C_{M0}}{C_{load}}) + \dfrac{\Delta d_M}{d_{M0}} \cdot (V_{ref} + k \cdot V_{M0} \cdot \dfrac{C_{M0}}{C_{load}})}$$

As can be seen, the signal term $\Delta d_M$ can be removed entirely from the denominator by choosing an appropriate value for the proportionality factor k, which may be negative in this case. Theoretically, this ideally compensates the distortion effect from the loaded MEMS sensor element CM with a counter-distortion effect from the analog-to-digital converter circuit ADC.

In particular, if the nominal values of the reference voltage VREF, the bias voltage VMO and the capacitances CMO and CLOAD are known, an appropriate value for the factor k can be easily calculated such that the expression within the brackets of equation (9) becomes zero.

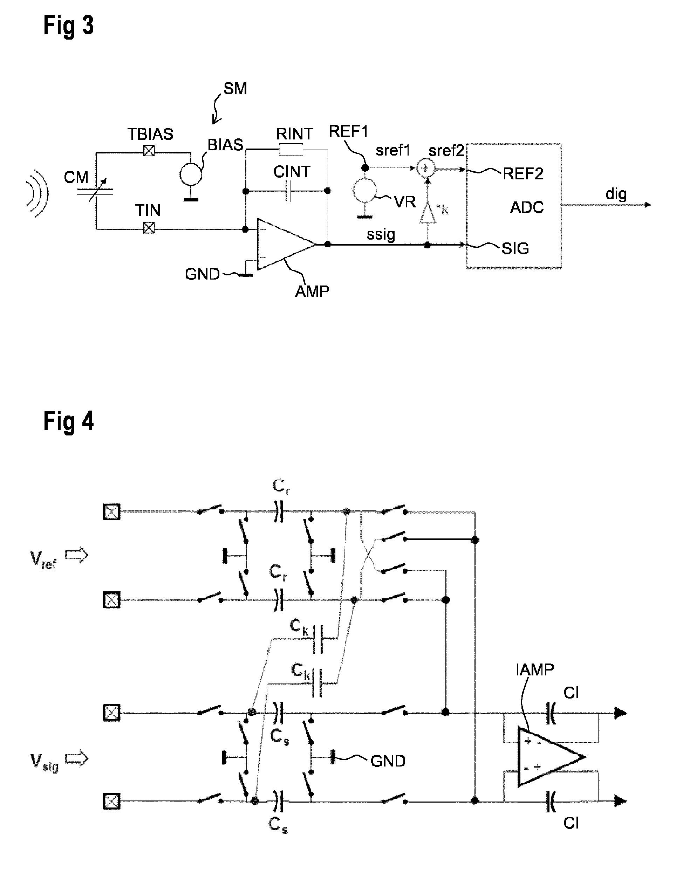

Figure 3 shows a further embodiment of a sensor arrangement, which again is based on the embodiment of the analog-to-digital converter system of Figure 1. Furthermore, the embodiment of Figure 3 is similar to that of Figure 2 with the exception of the amplification of the sensor signal by the amplifier circuit AMP.

Accordingly, the sensor module of Figure 3 comprises the capacitive MEMS sensor element CM that is connected between the bias terminal TBIAS and the input terminal TIN. The input terminal TIN is connected to an inverting input of the amplifier AMP, which is implemented as an operational amplifier, whose non-inverting input is connected to the ground terminal GND. The output of the operational amplifier AMP is fed back to the inverting input by means of an RC parallel connection, which includes an integration capacitor CINT and a parallel connected resistive element RINT.

Also in this configuration, capacitance of the capacitor CINT leads to a non-linear behaviour of the voltage signal resulting from variations of the MEMS sensor element CM. In particular, the integrator circuit formed by the operational amplifier AMP and the RC parallel connection RINT, CINT, provides a low impedance input to the sensor element CM. Therefore, if the capacitance value of the sensor element CM changes due to an acoustic signal, sensor charge is lost or shared into the integrator. The resulting distortion effect visible at the output of the operational amplifier AMP has a similar characteristic as with the capacitive load of Figure 2 and can be compensated by using the analog-to-digital converter system according to the improved concept. In particular, an appropriate factor k can be found that eliminates the non-linear effect.

In summary, the digital output signal dig has a completely or almost completely linear dependency on the displacement of the plates of the MEMS sensor module CM, resulting in a highly linear reproduction of the acoustic signal in both embodiments of Figure 2 and Figure 3.

Figure 4 shows a detail of a further embodiment of an analog-to-digital converter system. In particular, Figure 4 shows an example of how the second reference signal sref2 of the analog-to-digital converter circuit ADC can be modulated in a differential switched capacitor sigma delta frontend. The arrangement shown in Figure 4 comprises sampling capacitors $C_S$, reference capacitors $C_R$, integration capacitors CI connected to an integrated amplifier IAMP, and several switches. Such a configuration is known in the art. However, according to the improved concept, the arrangement of Figure 4 additionally comprises compensation capacitors $C_K$ which perform the modulation of the second reference signal sref2. It should be noted that, in this embodiment, the reference signals and the input signal are present in the form of charges or charge signals. The output of the integration amplifier will be converted to the digital signal in a well-known fashion, which is omitted here to enable a better overview. In this embodiment, the digital output signal dig is proportional to a ratio between the charge $Q_{sig}$ within the lower signal branch to the charge $Q_{\Sigma ref}$ within the upper reference branch. This may be expressed as

$$(10) \qquad Q_{\Sigma ref} = V_{ref} \cdot C_r + V_{sig} \cdot C_k$$

and

$$(11) \qquad Q_{sig} = V_{sig} \cdot C_s \, .$$

Taking $Q_{\Sigma ref}$ as the second reference signal sref2 and $Q_{sig}$ as the input signal ssig, equation (4) can be rewritten as:

$$(12) \qquad \text{dig} \sim \frac{Q_{sig}}{Q_{\Sigma ref}} = \frac{V_{sig} \cdot C_s}{V_{ref} \cdot C_r + V_{sig} \cdot C_k} = \frac{C_s}{C_r} \frac{V_{sig}}{V_{ref} + V_{sig} \cdot \frac{C_k}{C_r}}$$

It can thus be seen that

$$(13) \qquad k = \frac{C_k}{C_r} \, .$$

A negative sign of the factor k may be achieved in various ways. For example, the capacitors $C_k$ may be connected in a cross-connected fashion in the differential layout of the arrangement of Figure 4, which results in the opposite sign. Furthermore, the negative sign can be achieved by implementing a specific switching scheme. For example, with the arrangement of Figure 4, if the switches are controlled concurrently, a positive k will result, while a negative k can be achieved by controlling the switches in an opposite fashion.

It should be noted that there are furthermore applications possible, wherein the compensation of the non-linear effect within the input signal may be cancelled out by introducing a positive value of k, while in the above examples of Figure 2 and Figure 3k preferably is chosen as a negative value.

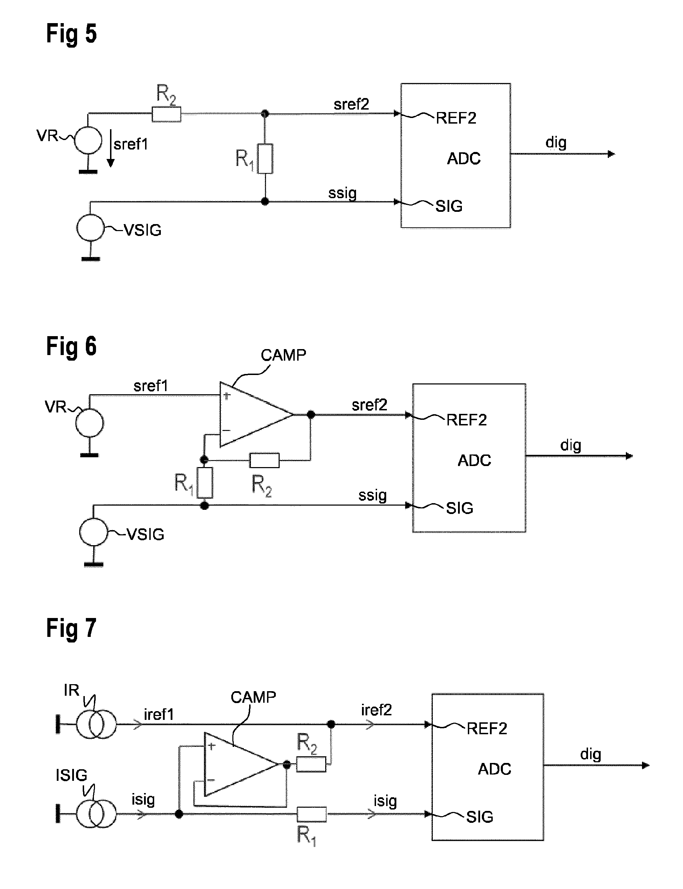

Figure 5 shows a further embodiment of an analog-to-digital converter system that is based on the idea presented with the embodiment of Figure 1. In particular, in the embodiment of Figure 5, the implementation of the proportionality factor k is performed by the resistive elements R1, R2. It can be easily deducted that the modulated second reference signal sref2 is achieved by

$$(14) \qquad \mathtt{sref2} = \frac{R_1}{R_1 + R_2} \cdot \left( \mathtt{sref1} + \frac{R_2}{R_1} \cdot \mathtt{ssig} \right).$$

Hence,

$$(15) \qquad k = \frac{R_2}{R_1}.$$

Figure 6 shows a further embodiment of an analog-to-digital converter system, wherein the modulation of the second reference signal sref2 is performed by means of an analog additional circuit with a compensation amplifier CAMP and resistors R1, R2. With this embodiment, a negative proportionality factor k can be achieved. The factor k can be determined by the resulting formula for the second reference signal sref2

$$(16) \qquad \mathtt{sref2} = \frac{R_1 + R_2}{R_1} \cdot \left( \mathtt{sref1} - \frac{R_2}{R_1 + R_2} \cdot \mathtt{ssig} \right)$$

to be

$$(17) \qquad k = -\frac{R_2}{R_1 + R_2}.$$

Figure 7 shows a further embodiment of an analog-to-digital converter system wherein the signals to be processed are current signals. The proportionality factor k is implemented by using the compensation amplifier CAMP and the resistors R1, R2, wherein the output current of the amplifier CAMP adds to the first reference current iref1 and results in the second reference current iref2. The input signal is implemented as the input current isig.
The value for the k factor can be calculated from

$$(18) \qquad \mathtt{iref2} = \mathtt{iref1} + \frac{R_1}{R_2} \cdot \mathtt{isig}$$

and results in

$$(19) \qquad k = \frac{R_1}{R_2}.$$

It should be noted that in the embodiments of Figure 5, Figure 6 and Figure 7, the entity producing the input signal is simply shown as a signal voltage source VSIG or a signal current source ISIG, respectively. However, these sources VSIG, ISIG are not part of the analog-to-digital converter system but may represent a sensor module providing a sensor signal or the like.

As can be seen from the various embodiments presented above, the proposed compensation of non-linear signal dependencies of a signal to be converted into the digital domain can be implemented with little additional circuit complexity compared to a conventional analog-to-digital converter. It has been shown that the effectiveness of the compensation can be increased, if the non-linearity to be compensated is based on a reciprocal dependency. In the latter case, the reciprocal dependency may be fully compensated by the modulated reference signal sref2.

It should be furthermore noted that the implementations shown in Figure 5, Figure 6 and Figure 7 are for single-ended signal processing. However, the underlying idea can easily be implemented with a differential design, as shown in the embodiment of Figure 4, for example. In this case of a differential implementation, also the provision of a specific sign for the proportionality factor k can be easily implemented by exchanging respective signal lines.

The circuit parts implementing the proportionality factor k may be variable, such that the proportionality factor k can be adapted during a calibration mode of operation or depending on specifications of the input signal. For example, the factor k may be selected depending on parameters of a sensor whose sensor signal is to be converted into the digital domain.

**Claims**

1. Analog-to-digital converter system, comprising

   - a reference terminal (REF1) for receiving an analog first reference signal (sref1), in particular fixed signal;
   - an analog-to-digital converter circuit (ADC) having a reference input (REF2) and a signal input (SIG) and being configured to generate a digital output signal (dig), which corresponds to an analog input signal (ssig) being present at the signal input (SIG), on the basis of the input signal (ssig) and an analog second reference signal (sref2) being present at the reference input (REF2); and
   - a reference compensation block (COMP), which is configured to generate the second reference signal (sref2) by superposing a signal being derived from the input signal (ssig) onto the first reference signal (sref1).

2. Analog-to-digital converter system according to claim 1, wherein the reference compensation block (COMP) is configured to generate the second reference signal (sref2) on the basis of a proportionality factor k, such that

$$\text{sref2} \approx \text{sref1} + k \cdot \text{ssig},$$

   with sref1 being the first reference signal, sref2 being the second reference signal, and ssig being the input signal.

3. Analog-to-digital converter system according to claim 2, which is configured to be operated in a normal mode of operation, during which the proportionality factor k is held constant, and in a calibration mode of operation, during which the proportionality factor k is adaptable.

4. Analog-to-digital converter system according to claim 2 or 3, wherein the proportionality factor k is selectable from a predetermined set of proportionality factors.

5. Analog-to-digital converter system according to one of claims 2 to 4, wherein the input signal (ssig) is a sensor signal that has a desired dependency on a quantity to be measured and further has a reciprocal dependency on the quantity to be measured, wherein the proportionality factor k is matched to the reciprocal dependency.

6. Analog-to-digital converter system according to one of claims 1 to 5, wherein the first reference signal (sref1), the second reference signal (sref2), and the input signal (ssig) are respectively one of the following:

   - a voltage signal;
   - a current signal;
   - a charge signal.

7. Analog-to-digital converter system according to one of claims 1 to 6, wherein the analog-to-digital converter circuit (ADC) comprises at least one of the following:

   - a direct conversion analog-to-digital converter;
   - a successive-approximation analog-to-digital converter;
   - an integrating analog-to-digital converter;
   - a sigma-delta analog-to-digital converter; and
   - a switched capacitor integrator.

8. Sensor arrangement with an analog-to-digital converter system according to one of claims 1 to 7, the sensor arrangement further comprising a sensor module (SM), whose output is connected to the signal input (SIG) of the analog-to-digital converter system for providing the input signal (ssig).

9. Sensor arrangement according to claim 8,
   wherein the sensor module (SM) comprises a capacitive sensor element for generating the input signal (ssig).

10. Sensor arrangement according to claim 9,
    wherein the sensor module (SM) comprises a capacitive microelectromechanical systems, MEMS, sensor element, in particular a MEMS microphone.

11. Sensor arrangement according to claim 10,
    wherein the sensor module (SM) comprises an amplifier circuit (AMP) and a bias voltage source (BIAS), and wherein the MEMS sensor element is connected between the bias voltage source (BIAS) and an amplifier input of the amplifier circuit (AMP).

12. Sensor arrangement according to claim 11,
    wherein the sensor module (SM) further comprises at least one of the following:

    - a high-ohmic resistive element (RB) that is connected between the amplifier input and a ground terminal (GND);
    - a capacitive element (CLOAD) that is connected between the amplifier input and the ground terminal (GND).

13. Sensor arrangement according to claim 11,
    wherein the amplifier circuit (AMP) is an operational amplifier, an amplifier output of the amplifier circuit (AMP) is connected to the amplifier input by an RC-parallel connection, and a further amplifier input is connected to a ground terminal (GND).

14. Method for analog-to-digital conversion, the method comprising:

    - receiving an analog first reference signal (sref1), in particular fixed signal;
    - receiving an analog input signal (ssig);
    - generating an analog second reference signal (sref2) by superposing a signal being derived from the input signal (ssig), in particular being proportional to the input signal (ssig), onto the first reference signal (sref1); and
    - generating a digital output signal (dig), which corresponds to the input signal (ssig), on the basis of the input signal (ssig) and the second reference signal (sref2).

15. Method according to claim 14,
    wherein the input signal (ssig) is a sensor signal that has a desired dependency on a quantity to be measured and further has a reciprocal dependency on the quantity to be measured, wherein a proportionality factor k, which is used for generating the second reference signal (sref2), is matched to the reciprocal dependency.

# Fig 1

# Fig 2

# Fig 3

# Fig 4

**Fig 5**

**Fig 6**

**Fig 7**

**EUROPEAN SEARCH REPORT**

Application Number

EP 12 19 7778

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | IGLESIAS G E ET AL: "LINEARIZATION OF TRANSDUCER SIGNALS USING AN ANALOG-TO-DIGITAL CONVERTER", IEEE TRANSACTIONS ON INSTRUMENTATION AND MEASUREMENT, IEEE SERVICE CENTER, PISCATAWAY, NJ, US, vol. 37, no. 1, 1 March 1988 (1988-03-01), pages 53-57, XP000029724, ISSN: 0018-9456, DOI: 10.1109/19.2663 \* figure 3 \* \* section IV,V \* \* equations 16,19,20,21; page 54 \* \* page 54, right-hand column, paragraphs 3,last \* \* page 55, right-hand column, paragraph 3 \* \* page 56, right-hand column, paragraphs 1,7 \* | 1-13 | INV. H03M1/06 |
| X | EP 0 464 777 A1 (ZUMTOBEL AG [AT]) 8 January 1992 (1992-01-08) \* figure 1 \* \* page 4, lines 31-32 \* | 1,2,6,14 | **TECHNICAL FIELDS SEARCHED (IPC)** H03M |
| X | US 4 764 751 A (KIMURA HIDEAKI [JP]) 16 August 1988 (1988-08-16) \* figure 2a \* | 1,2,6,14 | |
| X | US 3 239 833 A (GRAY JOHN W) 8 March 1966 (1966-03-08) \* column 1, lines 45-56; figure 3 \* \* column 7, lines 14-21 \* \* claim 2 \* | 1,2,6,14 | |

The present search report has been drawn up for all claims

| Place of search | Date of completion of the search | Examiner |
|---|---|---|
| The Hague | 30 May 2013 | Galardi, Leonardo |

EPO FORM 1503 03.82 (P04C01)

**ANNEX TO THE EUROPEAN SEARCH REPORT
ON EUROPEAN PATENT APPLICATION NO.**

EP 12 19 7778

This annex lists the patent family members relating to the patent documents cited in the above-mentioned European search report.
The members are as contained in the European Patent Office EDP file on
The European Patent Office is in no way liable for these particulars which are merely given for the purpose of information.

30-05-2013

| Patent document cited in search report | | Publication date | Patent family member(s) | | Publication date |
|---|---|---|---|---|---|
| EP 0464777 | A1 | 08-01-1992 | AT | 129367 T | 15-11-1995 |
| | | | DE | 4021131 A1 | 09-01-1992 |
| | | | EP | 0464777 A1 | 08-01-1992 |
| | | | FI | 913219 A | 04-01-1992 |
| US 4764751 | A | 16-08-1988 | EP | 0231950 A2 | 12-08-1987 |
| | | | JP | S62183677 A | 12-08-1987 |
| | | | US | 4764751 A | 16-08-1988 |
| US 3239833 | A | 08-03-1966 | NONE | | |

EPO FORM P0459

For more details about this annex : see Official Journal of the European Patent Office, No. 12/82